(19) Europäisches Patentamt
European Patent Office
Office européen des brevets

(11) **EP 4 200 625 B1**

(12) **FASCICULE DE BREVET EUROPEEN**

(45) Date de publication et mention de la délivrance du brevet:
**09.10.2024 Bulletin 2024/41**

(21) Numéro de dépôt: **21762734.8**

(22) Date de dépôt: **24.08.2021**

(51) Classification Internationale des Brevets (IPC):
***G01R 33/09*** *(2006.01)* ***G11C 11/16*** *(2006.01)*

(52) Classification Coopérative des Brevets (CPC):
**G01R 33/098; G11C 11/161; G11C 11/1675;**
G01R 33/0035

(86) Numéro de dépôt international:
**PCT/EP2021/073330**

(87) Numéro de publication internationale:
**WO 2022/043292 (03.03.2022 Gazette 2022/09)**

(54) **PROCÉDÉ DE MESURE D’UN CHAMP MAGNÉTIQUE EXTÉRIEUR PAR AU MOINS UN POINT MÉMOIRE MAGNÉTIQUE**

VERFAHREN ZUR MESSUNG EINES EXTERNEN MAGNETFELDES MIT MINDESTENS EINEM MAGNETSPEICHERPUNKT

METHOD FOR MEASURING AN EXTERNAL MAGNETIC FIELD USING AT LEAST ONE MAGNETIC MEMORY POINT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.08.2020 FR 2008638**

(43) Date de publication de la demande:
**28.06.2023 Bulletin 2023/26**

(73) Titulaires:
- **Commissariat à l’Energie Atomique et aux Energies Alternatives**
  **75015 Paris (FR)**
- **Centre National de la Recherche Scientifique (CNRS)**
  **75794 Paris Cedex 16 (FR)**

(72) Inventeurs:
- **SOUSA, Ricardo**
  **38054 Grenoble (FR)**
- **PREJBEANU, Ioan-Lucian**
  **38054 Grenoble (FR)**

(74) Mandataire: **Cabinet Camus Lebkiri**
**25 rue de Maubeuge**
**75009 Paris (FR)**

(56) Documents cités:
**EP-A1- 3 528 256**
**US-A1- 2005 073 371**
**US-A1- 2008 100 969**
**US-A1- 2009 015 972**
**US-A1- 2011 169 488**
**US-A1- 2015 213 868**
**US-A1- 2018 358 543**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Processed by Luminess, 75001 PARIS (FR)

## Description

### DOMAINE TECHNIQUE DE L'INVENTION

Le domaine technique de l'invention est celui de la spintronique et plus particulièrement des capteurs et des mémoires magnétiques fonctionnant grâce au principe de magnétorésistance tunnel.

La présente invention concerne un procédé permettant d'obtenir une fonctionnalité de capteur de champ magnétique linéaire basée sur l'utilisation d'au moins un élément de mémoire vive magnétique tel que par exemple une mémoire de type MRAM selon la dénomination anglo-saxonne « Magnetic Random-Access Memory ». On peut citer à titre d'exemple de ce type de mémoire MRAM, une jonction tunnel à anisotropie magnétique perpendiculaire

### ARRIERE-PLAN TECHNOLOGIQUE DE L'INVENTION

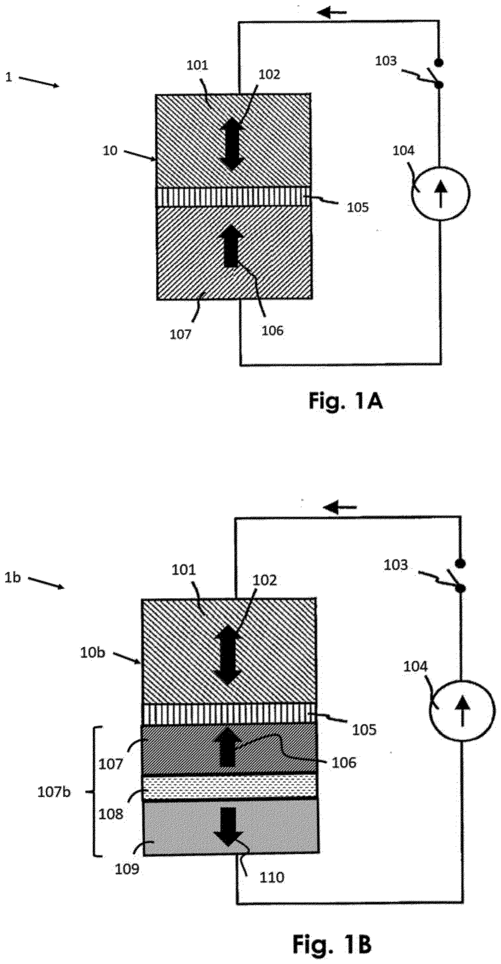

Les dispositifs MRAM à anisotropie perpendiculaire avec un mécanisme d'écriture basé sur le couple de transfert de spin comprennent, dans leur forme la plus simple, trois éléments. Un tel dispositif MRAM est représenté à la [Fig. 1A].

Le dispositif MRAM 1 représenté à la [Fig. 1A] comprend une jonction tunnel magnétique 10, la jonction tunnel magnétique 10 comprenant un couche de référence 107 de direction d'aimantation 106 fixe, une couche dite « libre » ou « de stockage » 101 de direction d'aimantation 102 variable entre deux états et une couche de barrière tunnel 105 séparant les deux couches 101 et 107, formant une jonction tunnel magnétique.

Dans un mode de réalisation privilégié de cette MRAM, les couches magnétiques 101 et 107 ont une anisotropie magnétique perpendiculaire, de sorte que la direction de magnétisation privilégiée est orthogonale à la surface du substrat. Le principe de fonctionnement le plus courant d'un tel dispositif MRAM 1 est d'avoir la couche de référence 107 avec une anisotropie magnétique beaucoup plus élevée par rapport à celle de la couche de stockage 101, de sorte que le champ magnétique nécessaire pour inverser la direction d'aimantation de la couche de stockage 101 est beaucoup plus faible que celui de la couche de référence 107. L'aimantation 106 de la couche de référence 107 peut être considérée comme fixe, pointant par exemple vers le haut sur la [Fig. 1A], tandis que l'aimantation 102 de la couche de stockage 101 peut prendre l'une des deux directions préférées, soit vers le haut, soit vers le bas, comme représenté à la [Fig. 1A].

L'état de la résistance du dispositif MRAM 1 peut être mesuré en mesurant la résistance de la jonction tunnel magnétique 10. La résistance mesurée en fonction du champ magnétique, varie entre une résistance minimale lorsque les aimantations 106 et 102 pointent dans la même direction et un état de résistance maximale pour des directions opposées.

Une méthode privilégiée pour passer d'un état de résistance à l'autre est d'appliquer un courant à travers une telle jonction tunnel magnétique 10. À une valeur seuil de flux de courant, le moment magnétique transféré par le courant polarisé en spin est suffisamment important pour inverser le sens d'aimantation 102 de la couche de stockage 101. La densité de courant de seuil jc peut être estimée comme suit :

$$j_c = \frac{2e}{\hbar}\frac{\alpha}{\eta}\mu_0\, M_s\, t\, (H_k + H_{eff})$$

Où e est la charge de l'électron, $\eta$ est la polarisation en spin, $\mu_0$ est la perméabilité au vide, h-bar la constante de Planck réduite, Ms la magnétisation de saturation, t l'épaisseur de la couche de stockage 101 et Hk l'anisotropie magnétique de la couche de stockage 101. Le champ magnétique Heff agissant sur la couche de stockage 101 résulte de la somme du champ externe et du champ dipolaire créé par la couche de référence 107. Ainsi, pour le fonctionnement de la mémoire, la jonction tunnel magnétique 10 du dispositif MRAM 1 aura généralement une couche de référence 107 conçue pour réduire ce champ dipolaire. Par exemple, cela peut être réalisé en divisant la couche de référence 107 en deux sous-couches magnétiques ayant des directions de magnétisation opposées comme représenté à la [Fig. 1B].

A la [Fig. 1B], le dispositif MRAM 1b comprend une jonction tunnel magnétique 10b comprenant une couche de stockage 101 ayant une direction d'aimantation 102, une couche de barrière tunnel 105 et une couche de référence 107b. La couche de référence 107b comprend trois sous-couches : une sous-couche magnétique 107 ayant une direction d'aimantation fixe 106 telle que celle du dispositif MRAM 10 de la [Fig. 1], une sous-couche magnétique 109 ayant une direction d'aimantation 110 et une sous-couche de couplage antiferromagnétique 108 permettant de coupler les sous-couches magnétiques 107 et 109 entre elles selon un couplage RKKY (« Ruderman-Kittel-Kasuya-Yosida »). Le couplage RKKY (« Ruderman-Kittel-Kasuya-Yosida ») est une interaction entre les moments magnétiques de deux couches magnétiques séparées par une couche non-magnétique. Ce couplage RKKY antiferromagnétique est assuré par la présence d'une couche non-magnétique espaceur entre les deux couches magnétiques couplées. En modifiant l'épaisseur de la couche non-magnétique espaceur, le couplage RKKY entre les deux couches magnétiques oscille et passe de ferromagnétique à antiferromagnétique. Ce phénomène est décrit par le document : Parkin et al, Phys. Rev. Lett. Vol 67 p 3598, 1991. En introduisant une couche de couplage 108 antiferromagnétique (par exemple en Ru, Ir, Ta ou Mo) entre les deux sous-couches magnétiques 107 et 109 de sorte que les deux sous-couches aient des directions d'aimantation opposées, on crée une structure antiferromagnétique synthétique (« SAF »). Une telle jonction tunnel magnétique 10b a un champ dipolaire inférieur au champ dipolaire de la jonction tunnel magnétique 10 de la [Fig. 1A].

Les dispositifs MRAM 1 et 1b décrits ci-dessus stockeront les informations dans la direction de l'aimantation 102, qui peut être lu à travers l'état de résistance de la jonction tunnel magnétique respectivement 10 et 10b. Le passage d'un état à l'autre peut être réalisé en appliquant un champ ou un courant supérieur à des valeurs seuils. Les caractéristiques de la courbe de transfert sont celles d'une courbe d'hystérésis, où dans une certaine gamme de champ ou de courant, les états de résistance élevés et faibles sont possibles, et au-dessus des seuils de commutation de champ ou de courant, un seul état de résistance devient possible. On entend par « un seul état de résistance » un état élevé, intermédiaire ou faible, chaque état de résistance n'étant pas défini par une unique valeur de résistance mais par un ensemble de valeurs de résistance, par exemple par un intervalle de résistances.

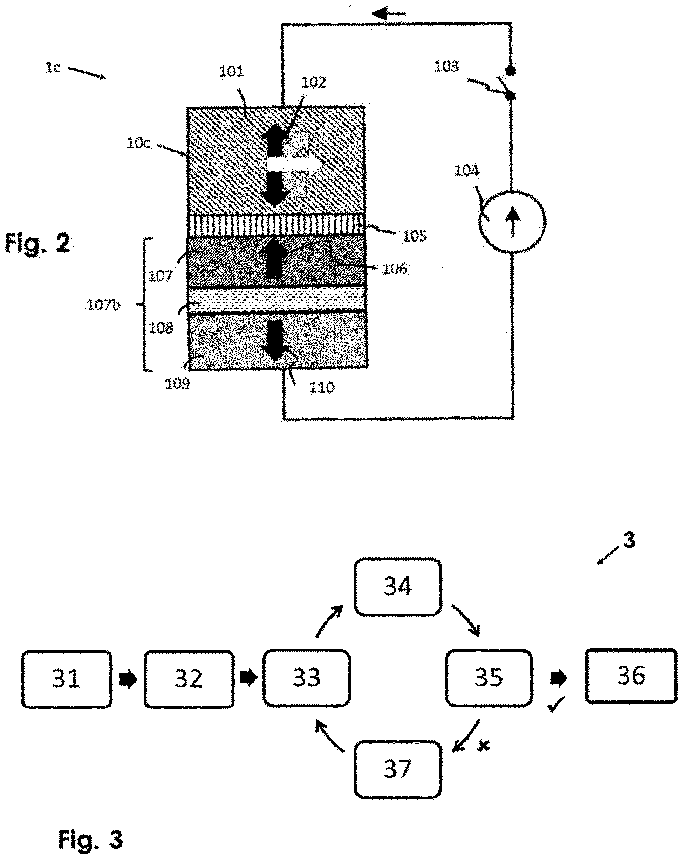

D'autre part, les capteurs de champ magnétique ayant des caractéristiques linéaires reposent sur des configurations magnétiques dans lesquelles l'aimantation de la couche de référence 107b et celle de la couche de détection 101 sont orthogonales entre elles. Ceci est illustré à la [Fig. 2], où la couche de détection 101 peut avoir une direction d'aimantation 102 qui est orthogonale à la direction d'aimantation de la couche de référence 107b en l'absence de champ (flèche blanche). Le capteur de champ magnétique 1c représenté à la [Fig. 2] peut aussi ne comprendre qu'une sous-couche de référence 107 à la place d'une SAF (Synthetic Anti-Ferromagnet correspondant à couche de référence de type une multicouche 107b) .

Pour un champ appliqué dans la direction verticale, c'est-à-dire perpendiculaire au plan des couches, l'aimantation peut tourner entre un alignement parallèle et un alignement antiparallèle avec la couche de référence 107b. En partant de la direction orthogonale à l'équilibre, la conductance électrique de la jonction tunnel magnétique 10c du capteur de champ magnétique 1c varie selon $\cos(\theta)$, $\theta$ étant l'angle relatif entre les directions d'aimantation de la couche de référence 107b et de la couche de détection 101. Pour un champ appliqué le long de l'axe d'aimantation de la couche de référence 107b, la résistance change presque linéairement avec le champ appliqué. Des techniques peuvent être utilisées pour linéariser davantage la sortie du capteur de champ 1c, par exemple en combinant plusieurs capteurs 1c ayant des directions de couche de référence 107b opposées dans un arrangement de pont de Wheatstone complet ou de demi-pont de Wheatstone. Cependant, chaque capteur a toujours les directions d'aimantation orthogonales entre les couches de détection 101 et de référence 107 ou 107b lorsqu'aucun champ magnétique n'est appliqué, au contraire d'une mémoire pour laquelle la direction d'aimantation des couches de détection 101 et de référence 107 ou 107b doit être alignée selon le même axe.

Comme les exigences d'alignement de l'aimantation à champ extérieur nul pour les opérations de la mémoire et du capteur sont si différentes, l'objectif de créer un capteur et une mémoire à partir du même empilement de matériaux nécessite un compromis entre les deux fonctionnalités. Il en résulte une co-intégration dégradée des deux types de dispositifs dans le même substrat, basée sur le même empilement magnétique.

Le document EP 3 528 256 A1 divulgue une mémoire et un capteur de l'art antérieur,

## RESUME DE L'INVENTION

L'invention offre une solution aux problèmes évoqués précédemment, en permettant d'étendre les fonctionnalités d'un point mémoire de stockage à anisotropie d'interface perpendiculaire au-delà de sa fonction de stockage d'informations, pour obtenir également une fonction de capteur de champ magnétique linéaire utilisant la même aimantation qui optimise le fonctionnement de la mémoire.

Un aspect de l'invention concerne ainsi un procédé de mesure de l'intensité d'un champ magnétique extérieur par l'utilisation d'au moins un point mémoire magnétique comprenant :

- une couche de stockage ayant une aimantation commutable entre deux directions d'aimantation sensiblement perpendiculaires au plan de la couche ;
- une couche de référence ayant une aimantation fixe et perpendiculaire au plan de la couche ;
- une couche barrière tunnel séparant la couche de stockage et la couche de référence ;

le procédé étant caractérisé en ce qu'il comprend au moins:

- une étape d'application successive d'une pluralité de courants ou de tensions d'amplitudes différentes audit au moins un point mémoire jusqu'à ce qu'une commutation de la direction d'aimantation de la couche de stockage ait lieu pour déterminer une valeur de courant minimal de commutation de la direction d'aimantation de la couche de stockage ou une valeur de tension minimale de commutation de la direction d'aimantation de la couche de stockage, une commutation de la direction d'aimantation de la couche de stockage étant le passage de la direction d'aimantation de la couche de stockage d'une configuration parallèle à la direction d'aimantation de la couche de référence à une configuration antiparallèle à la direction d'aimantation de la couche de référence ou le passage d'une configuration antiparallèle à la direction d'aimantation de la couche de référence à une configuration parallèle à la direction d'aimantation de la couche de référence en fonction d'une direction d'aimantation initiale de la couche de stockage,

- une étape de détermination de l'intensité du champ magnétique extérieur à mesurer à partir de la valeur du courant minimal de commutation ou de la valeur de la tension minimale de commutation.

On entend par « commutation » le passage de la direction d'aimantation de la couche de stockage d'une configuration parallèle à la direction d'aimantation de la couche de référence à une configuration antiparallèle à la direction d'aimantation de la couche de référence ou le passage d'une configuration antiparallèle à la direction d'aimantation de la couche de référence à une configuration parallèle à la direction d'aimantation de la couche de référence en fonction de la direction d'aimantation initiale.

La direction d'aimantation des couches de référence et de stockage étant orthogonales au plan des couches, on entend par « l'intensité du champ magnétique extérieur » l'intensité de la composante verticale du champ magnétique extérieur, c'est-à-dire l'intensité de la composante selon l'axe de la direction d'aimantation des couches de référence et de stockage.

On entend par « courant minimal de commutation ou tension minimale de commutation » le courant ou la tension le plus petit parmi ceux appliqués à la jonction tunnel magnétique après l'application duquel ou de laquelle la direction d'aimantation de la couche de stockage a été commutée.

Grâce à l'invention, l'intensité de la composante perpendiculaire du champ magnétique extérieur peut être obtenue à partir de la tension minimale de commutation ou du courant minimal de commutation du point mémoire magnétique, la tension minimale de commutation ou le courant minimal de commutation étant obtenu(e) par l'application successive de courants ou de tensions d'amplitudes différentes. On entend par application « successive d'une pluralité de courants ou tensions » une application de courants ou de tensions se suivant, que cette application soit discrète ou continue. Ainsi, par exemple l'application d'impulsions de tensions ou de courant et l'application d'une rampe de tensions ou de courants sont comprises dans une application successive d'une pluralité de courants ou tensions. L'invention utilise en effet avantageusement le fait que le courant et la tension varient essentiellement linéairement par rapport au champ magnétique extérieur appliqué, permettant d'avoir une différence de tension qui est essentiellement linéairement proportionnelle à l'intensité du champ magnétique extérieur.

Les mémoires magnétiques de l'état de l'art disposant déjà de moyens de lecture et d'écriture, la présente invention permet de réutiliser avantageusement ces moyens pour réaliser la fonctionnalité de captation d'intensité de champ magnétique.

Grâce à l'invention, les propriétés du capteur, telles que la sensibilité et la plage de champ, peuvent être ajustées uniquement en modifiant la surface du capteur (selon le plan des couches), sans qu'il soit nécessaire de modifier l'empilement de matériaux.

L'invention permet ainsi, avec le même empilement magnétique, d'avoir les deux fonctionnalités de stockage d'informations et de captation de champs magnétiques sans compromis sur la réalisation des fonctionnalités de stockage et de captation et en ayant un encombrement faible.

L'invention permet avantageusement de répondre aux différentes exigences de spécification des capteurs en ajustant simplement les dimensions latérales du point mémoire.

Outre les caractéristiques qui viennent d'être évoquées dans le paragraphe précédent, le procédé de mesure de l'intensité d'un champ magnétique extérieur selon un aspect de l'invention peut présenter une ou plusieurs caractéristiques complémentaires parmi les suivantes, considérées individuellement ou selon toutes les combinaisons techniquement possibles :

- ledit au moins un point mémoire est une jonction tunnel magnétique à aimantation hors du plan.

- l'étape de détermination de l'intensité du champ magnétique extérieur comprend en outre au moins les sous-étapes de :

  - calcul de la différence entre la valeur de courant minimale de commutation ou de la tension minimale de commutation et au moins une valeur de courant de commutation de référence ou de tension de commutation de référence mesurée selon le même procédé sous un champ magnétique extérieur de référence et

  - calcul d'une valeur d'intensité de champ magnétique comprenant la multiplication par une constante de proportionnalité de la différence entre la valeur de courant minimale de commutation ou de la tension minimale de commutation et la au moins une valeur de courant de commutation de référence ou de tension de commutation de référence et l'addition de la valeur obtenue à la valeur d'intensité du champ de référence.

- la constante de proportionnalité est déterminée en calculant un rapport entre la différence entre une valeur de courant de commutation de calibration ou de tension de commutation de calibration et une valeur de courant de commutation de référence ou de tension de commutation de référence et la différence entre une valeur d'intensité d'un champ magnétique de calibration et une valeur d'intensité du champ magnétique de référence. Cela permet notamment d'utiliser avantageusement la linéarité du rapport entre courant ou tension et intensité du champ magnétique appliqué pour déterminer la valeur du champ magnétique extérieur appliqué actuel.

- l'étape d'application successive d'une pluralité de courants ou de tensions d'amplitudes différentes jusqu'à ce qu'une commutation de la direction d'aimantation de la couche de stockage ait lieu comprend les sous-étapes de:

  - détermination d'une première résistance dudit au moins un point mémoire magnétique, la détermination de la première résistance comprenant la mesure d'un courant ou d'une tension aux bornes du point mémoire magnétique,

  - comparaison de la première résistance obtenue à une valeur de résistance de référence pour identifier une direction d'aimantation initiale relative de la couche de stockage par rapport à la couche de référence,

  - application audit au moins un point mémoire magnétique d'une impulsion de courant ou de tension d'une amplitude prédéfinie et d'une polarité favorisant la commutation de la couche de stockage vers une direction opposée à la direction d'aimantation initiale relative de la couche de stockage par rapport à la couche de référence,

  - détermination d'une deuxième résistance dudit au moins un point mémoire magnétique, la détermination de la deuxième résistance comprenant la mesure d'un courant ou d'une tension aux bornes du point mémoire magnétique après l'application au point mémoire magnétique d'une impulsion de courant ou de tension,

  - comparaison de la deuxième résistance obtenue à la valeur de résistance de référence pour déterminer si une commutation de la direction d'aimantation de la couche de stockage a eu lieu,

  - Si une commutation de la direction d'aimantation de la couche de stockage a eu lieu :

    - le courant minimal de commutation ou la tension minimale de commutation est le courant ou la tension appliqué à l'étape précédente d'application au point mémoire magnétique d'une impulsion de courant ou de tension,

  - Si une commutation de la direction d'aimantation de la couche de stockage n'a pas eu lieu, les sous-étapes d'application au point mémoire magnétique d'une impulsion de courant ou de tension, détermination d'une deuxième résistance et de comparaison de la deuxième résistance à la première résistance sont renouvelées avec une impulsion de courant ou de tension d'une amplitude modifiée différente de l'amplitude prédéfinie jusqu'à ce qu'une commutation de la direction d'aimantation de la couche de stockage ait lieu.

- l'amplitude prédéfinie est une amplitude basse et en ce que l'amplitude modifiée est supérieure à l'amplitude basse. Cela permet d'avoir une consommation d'énergie plus basse qu'en débutant par exemple par des courants ou tensions d'amplitude haute et en choisissant ensuite des amplitudes plus basses, le seuil de commutation étant dans ce cas déterminé par la première amplitude sans commutation de l'aimantation.

- l'étape d'application successive d'une pluralité de courants ou de tensions d'amplitudes différentes jusqu'à ce qu'une commutation de la direction d'aimantation de la couche de stockage ait lieu comprend les sous-étapes de:

  - Application d'une rampe ou d'un signal périodique de courant ou de tension, d'une polarité favorisant la commutation de la couche de stockage vers une direction opposée à la direction d'aimantation initiale relative de la couche de stockage par rapport à la couche de référence, jusqu'à ce qu'une commutation de la direction d'aimantation de la couche de stockage soit détectée,

  - Détermination de l'amplitude de courant minimale de commutation ou de tension minimale de commutation en fonction du temps total d'application de la rampe de courant ou de tension pour obtenir la valeur du courant minimal de commutation ou de la tension minimale de commutation.

- le procédé de mesure de l'intensité d'un champ magnétique extérieur comprend une étape supplémentaire d'application d'une impulsion après la détection d'une commutation de la direction d'aimantation de la couche de stockage, l'impulsion ayant une polarité favorisant la commutation de la couche de stockage vers la direction d'aimantation initiale relative de la couche de stockage par rapport à la couche de référence et ayant une amplitude supérieure à l'amplitude du courant minimal de commutation ou de la tension minimale de commutation.

- le procédé de mesure de l'intensité d'un champ magnétique extérieur utilise une pluralité de points mémoire magnétiques, et en ce que l'étape d'application successive d'une pluralité de courants ou de tensions d'amplitudes différentes est réalisée en parallèle pour les points mémoire magnétique de la pluralité de points mémoire magnétiques.

- l'étape d'application successive d'une pluralité de courants ou de tensions d'amplitudes différentes en parallèle est réalisée simultanément pour chaque point mémoire magnétique de la pluralité de points mémoire magnétiques et en ce que la valeur de courant minimal ou la valeur de tension minimale de commutation de la direction d'aimantation est la valeur de courant minimal ou de tension minimale de commutation de la direction d'aimantation de la couche de stockage de chaque point mémoire magnétique de la pluralité de points mémoire magnétiques. Cela permet notamment de replacer la mémoire à son état initial, c'est-à-dire à son état pré-mesure, si nécessaire.

Un autre aspect de l'invention concerne un point mémoire magnétique caractérisé en ce qu'il est configuré pour mettre en oeuvre le procédé de mesure d'un champ magnétique extérieur selon l'invention, et en ce qu'il comprend en outre un contrôleur configuré pour gérer la mesure de la résistance du point mémoire magnétique.

Outre les caractéristiques qui viennent d'être évoquées dans le paragraphe précédent, le procédé de mesure de l'intensité d'un champ magnétique extérieur selon un aspect de l'invention peut présenter une ou plusieurs caractéristiques complémentaires parmi les suivantes, considérées individuellement ou selon toutes les combinaisons techniquement possibles :

- le point mémoire magnétique comporte une jonction tunnel magnétique à aimantation hors du plan (ou anisotropie perpendiculaire)
- le point mémoire magnétique comprend en outre un générateur d'impulsions et le contrôleur est en outre configuré pour gérer le générateur d'impulsions,
- le point mémoire magnétique a des dimensions latérales inférieures à 200nm.

Un autre aspect de l'invention concerne un procédé de détermination de la distance relative entre un point mémoire magnétique selon un aspect de l'invention et un objet magnétique générant un champ magnétique entre 1mT et 500mT, le procédé étant caractérisé en ce qu'il comprend les étapes de :

- Mesure de la composante perpendiculaire d'un champ magnétique selon le procédé de mesure d'un champ magnétique extérieur selon l'invention en une pluralité de points de l'espace pour déterminer une amplitude et une direction du champ magnétique,
- Calcul de la distance relative entre la couche de stockage du point mémoire magnétique et l'objet magnétique à partir de simulations du champ magnétique généré par l'objet magnétique.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- Les figures 1a et 1b montrent une représentation schématique de dispositifs MRAM selon l'art antérieur,
- La figure 2 montre une représentation schématique d'un capteur de champ magnétique TMR selon l'art antérieur,
- La figure 3 montre une représentation schématique d'un procédé de mesure de l'intensité d'un champ magnétique selon un mode de réalisation de l'invention,
- La figure 4 montre une représentation schématique d'un dispositif MRAM pour la mise en oeuvre d'un procédé selon l'invention,
- La figure 5 montre un diagramme d'état de résistance d'un dispositif MRAM selon l'invention,
- La figure 6 montre un diagramme représentant la limite entre les états de résistance dans un dispositif MRAM,
- La figure 7 montre un diagramme représentant la non-linéarité observée en fonction de la dimension latérale du dispositif MRAM,
- La figure 8 montre une pluralité de diagrammes d'état de résistance pour différentes dimensions latérales de dispositifs MRAM,
- La figure 9 montre une représentation schématique d'un procédé de mesure de champ magnétique selon l'invention,
- La figure 10 montre un diagramme représentant le courant traversant un dispositif MRAM selon l'invention lorsqu'un signal périodique est appliqué.

**DESCRIPTION DETAILLEE**

Les figures sont présentées à titre indicatif et nullement limitatif de l'invention.

Sauf précision contraire, un même élément apparaissant sur des figures différentes présente une référence unique.

[Fig. 3] montre une représentation schématique d'un procédé de mesure de l'intensité d'un champ magnétique selon un premier mode de réalisation de l'invention.

Le procédé de mesure 3 de l'intensité d'un champ magnétique extérieur selon l'invention est par l'utilisation d'au moins un point mémoire magnétique comprenant une jonction tunnel magnétique à aimantation hors du plan. Les références des figures représentant des dispositifs MRAM de l'art antérieur seront reprises par la suite. La jonction tunnel magnétique du dispositif MRAM utilisé pour mettre en oeuvre le procédé 3 comprend au moins :

- une couche de stockage 101 ayant une aimantation 102 commutable entre deux directions d'aimantation sensiblement perpendiculaires au plan de la couche ;
- une couche de référence 107 ayant une aimantation 106 fixe et perpendiculaire au plan de la couche ;
- une couche barrière tunnel 105 séparant la couche de stockage 101 et la couche de référence 107.

On entend par « sensiblement perpendiculaire » une direction écartée de plus ou moins 15 degrés de la direction normale au plan des couches.

Dans un mode de réalisation préférentiel la jonction tunnel magnétique du dispositif MRAM utilisé pour mettre en oeuvre le procédé 3 comprend une SAF 107b avec deux couches magnétiques 107 et 109 couplées antiferromagnétiquement par une couche espaceur de couplage 108 afin d'avoir moins de champ dipolaire rayonné par le dispositif MRAM et ainsi avoir moins d'interférences pour réaliser les mesures de champ magnétique.

Dans un premier mode de réalisation de l'invention, le procédé 3 de mesure de l'intensité de la composante verticale d'un champ magnétique extérieur au dispositif MRAM comprend une première étape 31 de détermination d'une première résistance du point mémoire magnétique. Cette détermination peut par exemple être réalisée classiquement en réalisant une mesure d'une tension ou d'un courant aux bornes du point mémoire magnétique.

Le procédé 3 comprend ensuite une étape 32 de comparaison de la première résistance obtenue à une valeur de résistance de référence pour identifier une direction d'aimantation initiale relative de la couche de stockage 101 par rapport à la couche de référence 107 ou de la SAF 107b. On fera référence de la même manière à la couche de référence 107 ou à la SAF 107b par « couche de référence 107 ».

Cette étape 32 de comparaison de la résistance mesurée à au moins une résistance de référence permet de déterminer la direction d'aimantation initiale relative de la couche de stockage 101 par rapport à la couche de référence 107, c'est-à-dire de déterminer si l'alignement est parallèle ou antiparallèle. Une résistance élevée par rapport à un seuil de résistance est considérée comme un alignement de la direction d'aimantation entre les couches de stockage 101 et de référence 107 antiparallèle. Au contraire une résistance basse par rapport à un seuil de résistance est considérée comme un alignement de la direction d'aimantation 102 entre les couches de stockage 101 et de référence 107 parallèle. Ainsi, on est capable de déterminer la direction d'aimantation 102 de la couche de stockage 101 par apport à la direction d'aimantation 106 de la couche de référence 107.

Dans le procédé 3, la mesure de la première résistance est utilisée pour déterminer si la direction d'aimantation 102 de la couche de stockage 101 a été commutée, c'est-à-dire si la direction d'aimantation 102 de la couche de stockage 101 a changé pour passer d'un alignement antiparallèle à un état parallèle ou inversement d'un alignement parallèle à un état antiparallèle avec la direction d'aimantation 106 de la couche de référence 107. On ne s'éloigne pas de l'invention lorsque la direction d'aimantation relative de la couche de stockage 101 par rapport à la couche de référence 107 est déterminée d'une autre manière.

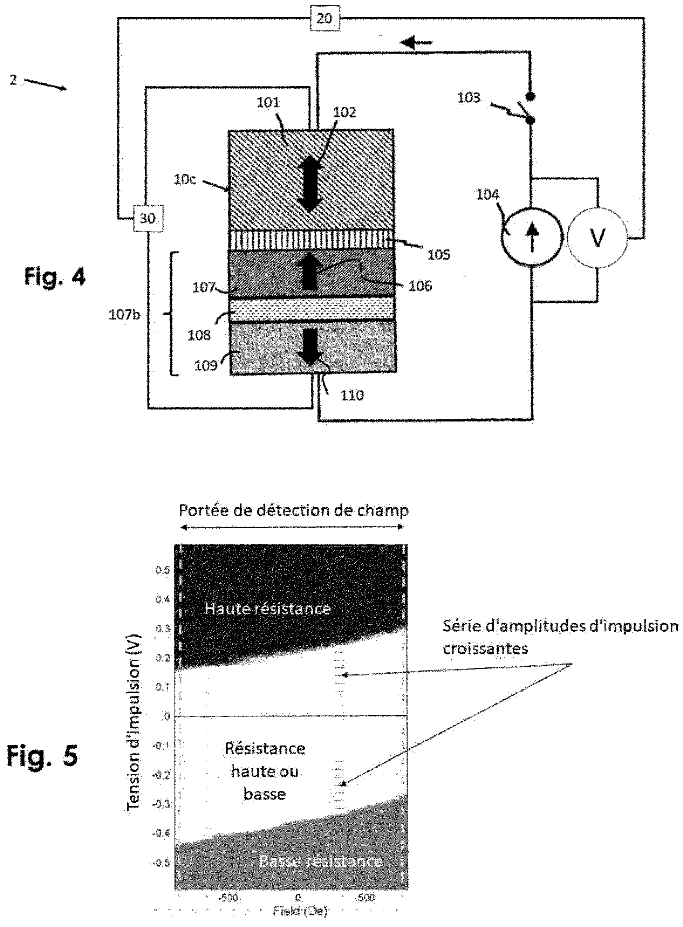

Le procédé 3 comprend une étape 33 d'application au point mémoire magnétique d'une impulsion de tension ou de courant d'une amplitude prédéfinie et d'une polarité favorisant la commutation de la couche de stockage vers une direction opposée à la direction d'aimantation 102 initiale relative de la couche de stockage 101 par rapport à la couche de référence 107. Cela peut être réalisé par des moyens utilisés classiquement pour l'écriture de la mémoire. On entend par « une polarité favorisant la commutation de la couche de stockage vers une direction opposée » une polarité positive ou négative en fonction de la direction d'aimantation 102 initiale mesurée, c'est-à-dire en fonction de la résistance initiale mesurée, et permettant la commutation de la direction d'aimantation 102 de la couche de stockage 101. Ceci est représenté à la [Fig. 5].

[Fig. 5] montre un diagramme d'état de résistance d'un dispositif MRAM. Ce diagramme représente notamment la tension d'impulsions en Volts en fonction du champ magnétique en Oersted, ainsi que la résistance en fonction de ces deux axes. Ainsi, en appliquant une impulsion de polarité positive dans le cas représenté à la [Fig. 5], on cherchera à rendre l'alignement antiparallèle, c'est-à-dire à passer d'une résistance basse à une résistance haute. Au contraire, en appliquant une impulsion de polarité négative dans le cas représenté à la [Fig. 5], on cherchera à rendre l'alignement parallèle, c'est-à-dire à passer d'une résistance haute à une résistance basse.

Le procédé 3 comprend une étape 34 de détermination d'une deuxième résistance du point mémoire magnétique, la détermination de la deuxième résistance comprenant la mesure d'une tension ou d'un courant aux bornes du point mémoire magnétique après l'application au point mémoire magnétique d'une impulsion de tension ou de courant à l'étape 33. Cette étape peut être réalisée de la même manière qu'à l'étape 31 du procédé 3.

Dans une étape 35 du procédé 3, on compare la deuxième résistance déterminée à l'étape 34 au même seuil de résistance que celui utilisé à l'étape 32 pour déterminer si une commutation de la direction d'aimantation 102 de la couche de stockage 101 a eu lieu.

Si une commutation de la direction d'aimantation 102 de la couche de stockage 101 n'a pas eu lieu, une étape 37 de modification de l'amplitude de la tension ou du courant appliqué à l'étape 33 est réalisée. Le procédé est alors repris à l'étape 33 d'application au point mémoire magnétique d'une impulsion de tension ou de courant de la même polarité que déterminée précédemment, mais d'amplitude modifiée telle que définie à l'étape 37.

Les étapes 33 à 35 sont renouvelées jusqu'à ce qu'une commutation de la direction d'aimantation 102 de la couche de stockage 101 ait lieu.

Préférentiellement, les impulsions sont toutes de même largeur temporelle. En effet, les variations de largeur d'impulsion pendant la séquence de commutation dégradent la résolution du champ, la largeur d'impulsion ne doit donc pas varier de manière significative tout au long de la séquence d'impulsion. La largeur d'impulsion peut prendre les mêmes valeurs que pour les utilisations en tant que mémoire, généralement supérieures mais proches de 1ns. Des largeurs d'impulsion plus importantes sont également possibles, mais pourraient entraîner une augmentation significative du temps total nécessaire à la réalisation du procédé 3 de mesure.

Si une commutation de la direction d'aimantation 102 de la couche de stockage 101 a été détectée à l'étape 35, alors le courant minimal de commutation ou la tension minimale de commutation est le courant ou la tension appliqué à l'étape précédente 33 d'application au point mémoire magnétique d'une impulsion de tension ou de courant.

Cela est représenté à la [Fig. 5], où des impulsions successives sont appliquées au dispositif MRAM. Un changement de direction d'aimantation 102 de la couche de stockage 101 est détecté lorsque les impulsions ont une amplitude suffisante et la bonne polarité pour commuter la direction d'aimantation 102 de la couche de stockage 101. Par exemple, à la [Fig. 5], lorsque le champ magnétique extérieur est d'environ 300 Oe, et que l'alignement initial des directions d'aimantation entre les couches de stockage 101 et de référence 107 est parallèle, c'est-à-dire lorsque la résistance mesurée est basse, une amplitude minimale d'environ 0.23 Volts et une polarité positive sont nécessaires pour commuter la direction d'aimantation 102 de la couche de stockage 101 et ainsi rendre l'alignement antiparallèle. Si, au contraire, l'alignement initial des directions d'aimantation entre les couches de stockage 101 et de référence 107 est antiparallèle, c'est-à-dire lorsque la résistance mesurée est haute, une amplitude minimale d'environ 0.38 Volts et une polarité négative sont nécessaires pour commuter la direction d'aimantation 102 de la couche de stockage 101 et ainsi rendre l'alignement parallèle.

Préférentiellement, afin d'avoir la consommation d'énergie plus basse, on débutera à une amplitude prédéfinie basse, par exemple proche de 0, et on augmentera l'amplitude avec chaque nouvelle impulsion. Cela permet de consommer moins d'énergie qu'en débutant par exemple par des courants ou tensions d'amplitude haute et en choisissant ensuite des amplitudes plus basses.

Lorsqu'une commutation de la direction d'aimantation 102 de la couche de stockage 101 a été détectée à l'étape 35, une étape 36 de détermination de l'intensité du champ magnétique extérieur à partir de la valeur du courant minimal ou de la tension minimale de commutation de la direction d'aimantation 102 de la couche de stockage 101 est réalisée. Cette étape de détermination est permise grâce au fait le courant et la tension varient essentiellement linéairement par rapport au champ magnétique extérieur appliqué. Ainsi, l'intensité de la composante vertical du champ magnétique peut être déterminée en calculant la différence entre la valeur de la tension minimale de commutation ou du courant minimal de commutation obtenue à l'étape 35 et au moins une valeur de courant de commutation de référence ou de tension de commutation de référence mesurée selon le même procédé sous un champ magnétique extérieur de référence. Cette différence est ensuite multipliée par une constante de proportionnalité et additionnée à la valeur d'intensité de la composante orthogonale du champ de référence. Par exemple, le champ de référence peut être le champ nul. Dans cet exemple, la différence entre l'amplitude de la tension minimale ou du courant minimal de commutation et l'amplitude de la tension minimale de référence ou du courant minimal de référence multipliée par la constante de proportionnalité est égale à la valeur d'intensité de la composante orthogonale du champ magnétique extérieur pendant la mesure.

La constante de proportionnalité peut être déterminée en calculant un rapport entre la différence entre une valeur de tension de commutation de calibration ou de courant de commutation de calibration et une valeur de tension de commutation de référence ou de courant de commutation de référence et la différence entre une valeur d'intensité d'un champ magnétique de calibration et une valeur d'intensité du champ magnétique de référence. Ainsi, la constante de proportionnalité est déterminée en utilisant la caractéristique linéaire de la variation de tension ou courant par rapport au champ magnétique extérieur appliqué, en réalisant un calcul de pente préalable à toute mesure. Grâce à ce calcul de pente en prenant en compte deux champs magnétique : un de référence et un de calibration, on obtient la constante de proportionnalité qui permet par la suite de mettre en relation la tension minimale ou le courant minimal ayant permis de commuter la direction d'aimantation 102 de la couche de stockage 101 avec le champ magnétique extérieur. Il est ainsi possible de déterminer la valeur d'intensité de la composante verticale du champ magnétique extérieur à partir de la valeur du courant minimal ou de la tension minimale de commutation.

La précision de la mesure peut être accrue en appliquant le procédé 3 de manière répétée et en faisant la moyenne des valeurs de courant minimal ou tension minimale de commutation successives. Cela peut être réalisé en appliquant successivement le procédé 3 décrit ci-dessus pour déterminer les valeurs de courant minimal ou tension minimale de commutation des deux sens de commutation de la couche de stockage : de résistance faible à élevée et de résistance élevée à faible. En faisant la moyenne dans chaque sens des valeurs de courant minimal ou tension minimale de commutation, puis en soustrayant la moyenne de chacune des deux valeurs de courant minimal ou tension minimale de commutation sous un champ externe appliqué nul, on obtient une différence de tension qui est essentiellement linéairement proportionnelle à l'amplitude du champ externe. Cela permet d'améliorer la mesure de champ magnétique extérieur mais nécessite un temps plus long et une consommation d'énergie plus élevé.

Dans un deuxième mode de réalisation, la valeur de la tension minimale de commutation ou du courant minimal de commutation est déterminée en appliquant, à la place des impulsions, une rampe de tension ou de courant, d'une polarité favorisant la commutation de la couche de stockage vers une direction opposée à la direction d'aimantation initiale relative de la couche de stockage par rapport à la couche de référence, jusqu'à ce qu'une commutation de la direction d'aimantation de la couche de stockage soit détectée. Une alternative à cette rampe peut consister en l'utilisation de tout signal périodique comprenant une partie monotone ascendante suivie par une partie monotone descendante. L'amplitude de la tension minimale de commutation ou du courant minimal de commutation est ensuite déterminée en fonction du temps total d'application de la rampe de tension ou de courant pour obtenir la valeur de la tension minimale de commutation ou du courant minimal de commutation en connaissant la pente de la rampe. Dans ce deuxième mode de réalisation, les étapes 33, 34, 35 et 37 sont remplacées par l'application d'une rampe de tension ou de courant et la détection d'une commutation de la direction d'aimantation 102 de la couche de stockage 101. Les autres étapes restent inchangées 31, 32 et 36 sont nécessaires au procédé 3 selon le deuxième mode de réalisation de l'invention.

Avec une rampe de courant ou un signal périodique, une variation continue de la tension mesurée est induite. Lors du retournement de l'aimantation, cette variation est très rapide, par exemple de l'ordre de la nano seconde, due au changement de résistance. Pour détecter une commutation de la direction d'aimantation, il est possible d'utiliser un filtre passe-haut qui bloque les variations de signal de basse fréquence (variation de la rampe) et laisse passer les hautes fréquences (commutation de l'aimantation).

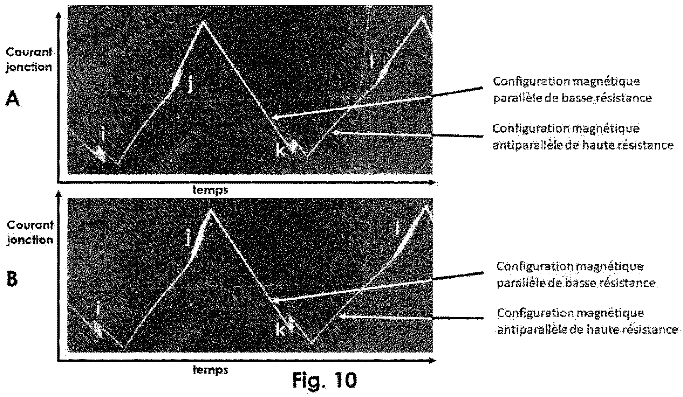

Par exemple, la [Fig. 10] montre un diagramme représentant le courant traversant un dispositif MRAM lorsqu'un signal périodique est appliqué selon le deuxième mode de réalisation de l'invention. A la figure 10, un signal de tension triangulaire est appliqué, comprenant une partie monotone ascendante et une partie monotone descendante. La Figure 10 montre une trace d'oscilloscope représentant le courant traversant le dispositif MRAM. Les abscisses représentent le temps, par exemple à la Figure 10 2 microsecondes par division, et les ordonnées représentent la tension, par exemple à la Figure 10 20 millivolts par division. Les valeurs en abscisses et en ordonnées ne sont pas limitatives. Ainsi, ce qui est représenté par l'axe des ordonnées est indirectement le courant traversant le dispositif MRAM. Ce courant peut par exemple être calculé comme 50 Ohm fois la tension mesurée à l'oscilloscope, dans le cas actuel dans lequel l'oscilloscope est configuré avec une impédance interne de 50 Ohm. La valeur de courant exacte dépend de la résistance du dispositif MRAM et de la tension appliquée. La tension appliquée sur le dispositif MRAM à la Figure 10 est une onde triangulaire, qui peut être ajustée en amplitude et offset pour atteindre les tensions positive et négative qui déclenchent la commutation de la jonction. Dans la partie A de la figure 10, le champ magnétique externe appliqué favorise une configuration parallèle de la direction de la couche de stockage 101, tandis que dans la partie B le champ magnétique externe appliqué favorise une configuration antiparallèle de la direction de la couche de stockage 101. Les seuils de commutation i à l, c'est-à-dire les changements d'états de résistance sont ainsi augmentés ou abaissés en fonction du champ magnétique appliqué. On remarque que la partie monotone descendante entre les seuils de commutation j et k est plus grande dans la partie A que dans la partie B, le seuil de commutation k dans la partie B ayant été remonté sur cette pente par la présence du champ magnétique favorisant une configuration antiparallèle. De même, le point j a été remonté sur la pente montante dans la partie B, c'est-à-dire qu'il est situé plus haut sur l'axe des ordonnées. Le dispositif change d'état de résistance à chaque seuil de commutation i à k, à des seuils de tension différents, avec des zones de transition montrées par les discontinuités de la pente. La figure 10 montre ainsi qu'il n'y a pas un changement net d'état de résistance mais plutôt des zones de transition aux seuils de commutation.

Pour l'application d'un signal périodique, une autre méthode peut être mise en oeuvre. Si les seuils de tension ou de courant de commutation de l'aimantation de chaque polarité tels que représentés par exemple à la [Fig. 5] sont symétriques, c'est-à-dire si leurs normes sont égales, le temps passé en résistance haute et celui passé en résistance basse sont identiques et une tension DC nulle est obtenue pour l'intégration d'un cycle complet. Si les seuils de tensions ou de courant de commutation de chaque polarité sont asymétriques, c'est-à-dire si la valeur absolue du seuil de tension ou de courant de polarité négative est différente de la valeur absolue du seuil de tension ou de courant de polarité positive, la valeur DC obtenue pour l'intégration d'un cycle complet est non-nulle et proportionnelle à l'asymétrie des seuils de polarité différente et permet alors de calculer le champ externe en utilisant par exemple le diagramme d'état de résistance à la [Fig. 5].

Le procédé 3 selon le premier ou le deuxième mode de réalisation de l'invention peut en outre comprendre une étape supplémentaire d'application d'une impulsion après la détection d'une commutation de la direction d'aimantation 102 de la couche de stockage 101, l'impulsion ayant une polarité favorisant la commutation de la couche de stockage 101 vers la direction d'aimantation initiale relative de la couche de stockage 101 par rapport à la couche de référence 107 et ayant une amplitude supérieure à l'amplitude du courant minimal de commutation ou de la tension minimale de commutation, ce afin de restaurer l'état initial du point mémoire magnétique et de ne pas impacter sa fonctionnalité de stockage d'informations.

La [Fig. 4] représente un dispositif MRAM 2 utilisé pour mettre en oeuvre le procédé 3 selon le premier mode de réalisation de l'invention.

Le dispositif MRAM 2 comprend une jonction tunnel magnétique 10c telle que décrite précédemment, ainsi qu'un contrôleur 20 et un générateur d'impulsions 30. Le contrôleur 20 est configuré pour gérer la mesure de la résistance de la jonction tunnel magnétique 10c aux étapes 31 et 34 du procédé 3 selon le premier mode de réalisation de l'invention. On entend par « gérer » la mesure de la résistance toutes les étapes nécessaires pour obtenir une mesure de résistance par le contrôleur 20, comprenant par exemple, en fonction du contrôleur utilisé, l'envoi d'un signal de requête de mesure de résistance et la réception d'un signal de mesure de résistance, par exemple la réception d'une valeur de tension ou de courant appliqué à la jonction tunnel magnétique. Le contrôleur 20 est en outre configuré pour gérer le générateur d'impulsions 30 et notamment l'amplitude des impulsions de tension ou de courant et pour réaliser au moins une partie des calculs compris dans le procédé 3, par exemple la détermination de la valeur de l'intensité du champ magnétique, préférentiellement tous les calculs compris dans le procédé 3.

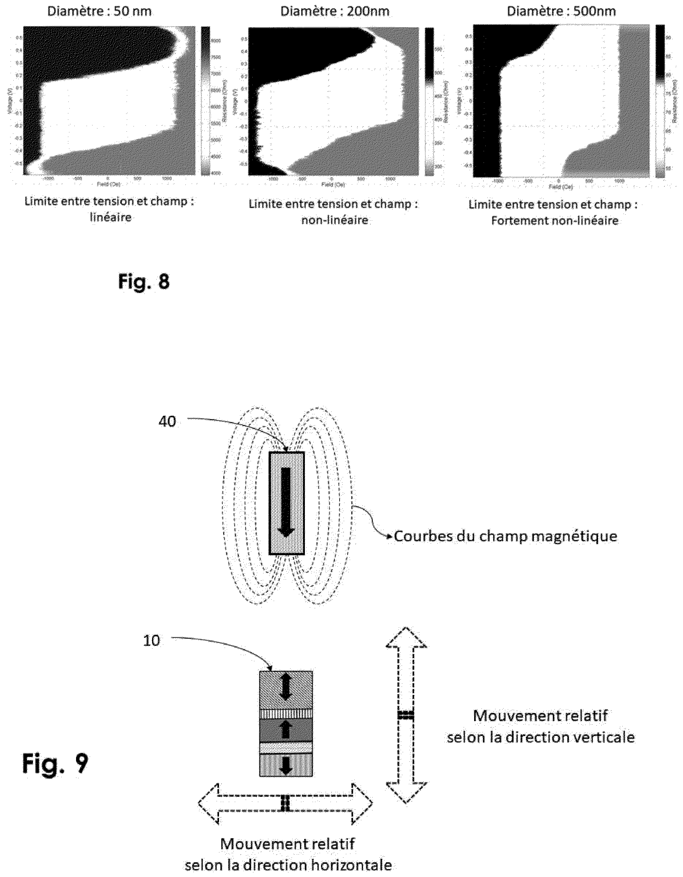

Le dispositif MRAM 2 doit avoir des dimensions telles que le fonctionnement du capteur soit optimisé pour la linéarité du capteur et la portée du champ. Ceci est rendu possible en ayant des dimensions latérales de la couche de stockage 101 inférieures à 200 nm. Par « dimensions latérales » on entend par exemple diamètre d'un cercle, grand axe d'une ellipse, longueur ou largeur dans le plan des couches en fonction de la géométrie de l'empilement magnétique. Pour ces dimensions latérales inférieures à 200nm, la linéarité de la tension de commutation par rapport au champ magnétique extérieur est améliorée. Les dimensions latérales supérieures à 200 nm montrent une nette déviation de la dépendance linéaire, avec un comportement non linéaire significatif à 500 nm et plus, comme représenté à la [Fig. 8].

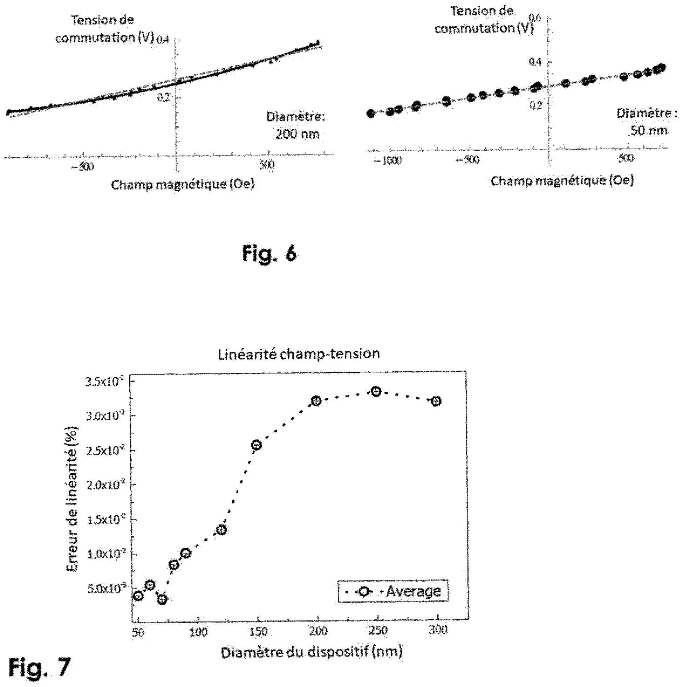

Idéalement, la taille latérale de la couche de détection devrait être inférieure à 60 nm, afin d'avoir un taux d'erreur de linéarité inférieur à 5 * $10^{-3}$ %, comme représenté à la [Fig. 7].

En fonction des dimensions latérales du point mémoire, la tension minimal ou le courant minimal de commutation est modifiée. Cela est représenté à la [Fig. 6], où deux diagrammes représentent les tensions minimales de commutation en Volts pour deux diamètres différents, un de 50nm et un de 200nm. La taille limite inférieure est déterminée par la surface nécessaire pour que l'aimantation 102 de la couche de stockage 101 soit perpendiculaire au plan de la couche.

La stabilité perpendiculaire de la couche de stockage (ou de détection en utilisation capteur) 102 est assurée pendant le temps de mesure $t_m$ pour la condition :

$$e^{\Delta} > \frac{t_m}{\tau_0}$$

Où $\tau_0$ est le temps d'une tentative de commutation (impulsion de commutation) généralement estimé autour de 1ns, et $\Delta$ est le facteur de stabilité thermique, correspondant au rapport entre l'énergie nécessaire pour inverser la direction d'aimantation et l'énergie thermique ($k_B T$). La stabilité thermique du point mémoire peut être calculée à partir de l'anisotropie effective Keff, et par convention Keff a une valeur positive pour l'anisotropie magnétique perpendiculaire. Dans le cas d'une anisotropie magnétique perpendiculaire à partir de l'interface, Keff peut être calculé à partir de l'anisotropie de surface (Ks), de l'épaisseur de la couche (t) et de l'aimantation à saturation. Le facteur de stabilité thermique peut être estimé comme suit pour un élément magnétique :

$$\Delta = \frac{K_{eff}\,V}{k_B\,T}, \qquad K_{eff} = \frac{K_s}{t} - 2 * \pi\, M_s^2$$

Pour les valeurs communes de l'anisotropie de l'interface magnétique perpendiculaire, les couches de stockage 102 typiques sont d'environ 1 à 2 nm, adjacentes à une barrière de tunnel fournissant une anisotropie interfaciale perpendiculaire. L'exigence minimale de stabilité pour le fonctionnement de la mémoire fixe une limite inférieure typique de dimension latérale de 15 à 20 nm. Dans la plage inférieure à 20 nm, la stabilité thermique de la cellule est réduite, ce qui entraîne une baisse des tensions de commutation, une réduction de la plage linéaire et une modification de la tension d'impulsion et de la sensibilité. Ainsi, les dimensions latérales peuvent être ajustées pour répondre aux différentes exigences de spécification du capteur.

Le procédé 3 selon le premier ou le deuxième mode de réalisation peut être utilisé avec plusieurs dispositifs MRAM. Lorsque le procédé 3 est utilisé avec plusieurs dispositifs MRAM, les impulsions de courant ou de tension, la rampe de courant ou de tension ou le signal périodique de courant ou de tension sont appliqués en parallèle sur les différents dispositifs MRAM. Cette application peut être simultanée (à plusieurs dispositifs MRAM en parallèle en même temps) ou successive (à chaque dispositif MRAM individuellement). Par exemple, un même contrôleur 20 peut gérer l'application du procédé 3 pour tous les dispositifs MRAM. Dans le cas où l'application à plusieurs dispositifs MRAM est réalisée simultanément, l'amplitude du courant ou la tension est modifiée jusqu'à obtenir la commutation de tous les dispositifs MRAM gérés.

Un autre objet de l'invention concerne l'utilisation du procédé 3 de mesure de l'intensité du champ magnétique par au moins un point mémoire pour déterminer la distance relative entre le point mémoire et un objet magnétique produisant un champ magnétique de 1mT à 500mT. Cela est représenté à la [Fig. 9], où un objet magnétique 40 est placé à une certaine distance du point mémoire magnétique 10. Le point mémoire magnétique 10 mettant en oeuvre le procédé 3 est capable de mesurer le champ magnétique extérieur généré par l'objet magnétique 40.

Avec une connaissance approximative de la géométrie de l'objet magnétique 40, il est possible de déterminer la distance verticale et horizontale relative entre l'objet 40 et la couche de stockage 102 du point mémoire 10. Pour ce faire, il est nécessaire de déterminer la composante perpendiculaire du champ magnétique généré par l'objet magnétique 40 par un mouvement de balayage relatif de la couche de stockage 102. Le procédé 3 de mesure de l'intensité du champ magnétique est appliqué en plusieurs points dans l'espace, idéalement en tous points de l'espace, pour déterminer l'amplitude et la direction du champ magnétique généré par l'élément magnétique 40. Les valeurs mesurées peuvent être utilisées pour calculer la distance relative entre le point mémoire 10 et l'objet magnétique 40 sur la base de simulations du champ magnétique généré par l'objet magnétique 40. La détection peut être effectuée avec un ou plusieurs points mémoire 10, disposés selon différentes orientations relatives afin d'avoir une détection par rapport aux diverses composantes du champ magnétique généré par l'objet 40. Les points mémoire multiples peuvent être arrangés en sonde pour augmenter la précision de détection par interpolation ou en s'adaptant à un comportement physique attendu du système.

**Revendications**

**1.** Procédé (3) de mesure de l'intensité d'un champ magnétique extérieur par l'utilisation d'au moins un point mémoire (10 ; 10b ; 10c) magnétique comprenant :

- une couche de stockage (101) ayant une aimantation (102) commutable entre deux directions d'aimantation sensiblement perpendiculaires au plan de la couche ;
- une couche de référence (107) ayant une aimantation (106) fixe et perpendiculaire au plan de la couche ;
- une couche barrière tunnel (105) séparant la couche de stockage (101) et la couche de référence (107) ;

le procédé étant **caractérisé en ce qu'**il comprend au moins:

- une étape d'application successive d'une pluralité de courants ou de tensions d'amplitudes différentes audit au moins un point mémoire jusqu'à ce qu'une commutation de la direction d'aimantation de la couche de stockage ait lieu pour déterminer une valeur de courant minimal de commutation de la direction d'aimantation de la couche de stockage ou une valeur de tension minimale de commutation de la direction d'aimantation de la couche de stockage, une commutation de la direction d'aimantation de la couche de stockage étant le passage de la direction d'aimantation de la couche de stockage d'une configuration parallèle à la direction d'aimantation de la couche de référence à une configuration antiparallèle à la direction d'aimantation de la couche de référence ou le passage d'une configuration antiparallèle à la direction d'aimantation de la couche de référence à une configuration parallèle à la direction d'aimantation de la couche de référence en fonction d'une direction d'aimantation initiale de la couche de stockage,
- une étape de détermination de l'intensité du champ magnétique extérieur à mesurer à partir de la valeur du courant minimal de commutation ou de la valeur de la tension minimale de commutation.

**2.** Procédé (3) de mesure de l'intensité d'un champ magnétique extérieur selon la revendication précédente **caractérisé en ce que** ledit au moins un point mémoire (10 ; 10b ; 10c) est une jonction tunnel magnétique à aimantation hors du plan.

**3.** Procédé (3) de mesure de l'intensité d'un champ magnétique extérieur selon la revendication 1 ou 2 **ca-**

**ractérisé en ce que** l'étape de détermination de l'intensité du champ magnétique extérieur comprend en outre au moins les sous-étapes de :

- calcul de la différence entre la valeur de courant minimale de commutation ou de la tension minimale de commutation et au moins une valeur de courant de commutation de référence ou de tension de commutation de référence mesurée selon le même procédé sous un champ magnétique extérieur de référence et
- calcul d'une valeur d'intensité de champ magnétique comprenant la multiplication par une constante de proportionnalité de la différence entre la valeur de courant minimale de commutation ou de la tension minimale de commutation et la au moins une valeur de courant de commutation de référence ou de tension de commutation de référence et l'addition de la valeur obtenue à la valeur d'intensité du champ de référence.

**4.** Procédé (3) de mesure de l'intensité d'un champ magnétique extérieur selon la revendication précédente **caractérisé en ce que** la constante de proportionnalité est déterminée en calculant un rapport entre la différence entre une valeur de courant de commutation de calibration ou de tension de commutation de calibration et une valeur de courant de commutation de référence ou de tension de commutation de référence et la différence entre une valeur d'intensité d'un champ magnétique de calibration et une valeur d'intensité du champ magnétique de référence.

**5.** Procédé (3) de mesure de l'intensité d'un champ magnétique extérieur selon l'une quelconque des revendications précédentes **caractérisé en ce que** l'étape d'application successive d'une pluralité de courants ou de tensions d'amplitudes différentes jusqu'à ce qu'une commutation de la direction d'aimantation de la couche de stockage ait lieu comprend les sous-étapes de:

- détermination d'une première résistance dudit au moins un point mémoire magnétique, la détermination de la première résistance comprenant la mesure d'un courant ou d'une tension aux bornes du point mémoire magnétique,
- comparaison de la première résistance obtenue à une valeur de résistance de référence pour identifier une direction d'aimantation initiale relative de la couche de stockage par rapport à la couche de référence,
- application audit au moins un point mémoire magnétique d'une impulsion de courant ou de tension d'une amplitude prédéfinie et d'une polarité favorisant la commutation de la couche de stockage vers une direction opposée à la direction d'aimantation initiale relative de la couche de stockage par rapport à la couche de référence,
- détermination d'une deuxième résistance dudit au moins un point mémoire magnétique, la détermination de la deuxième résistance comprenant la mesure d'un courant ou d'une tension aux bornes du point mémoire magnétique après l'application au point mémoire magnétique d'une impulsion de courant ou de tension,
- comparaison de la deuxième résistance obtenue à la valeur de résistance de référence pour déterminer si une commutation de la direction d'aimantation de la couche de stockage a eu lieu,
- Si une commutation de la direction d'aimantation de la couche de stockage a eu lieu :

  o le courant minimal de commutation ou la tension minimale de commutation est le courant ou la tension appliqué à l'étape précédente d'application au point mémoire magnétique d'une impulsion de courant ou de tension,

- Si une commutation de la direction d'aimantation de la couche de stockage n'a pas eu lieu, les sous-étapes d'application au point mémoire magnétique d'une impulsion de courant ou de tension, détermination d'une deuxième résistance et de comparaison de la deuxième résistance à la première résistance sont renouvelées avec une impulsion de courant ou de tension d'une amplitude modifiée différente de l'amplitude prédéfinie jusqu'à ce qu'une commutation de la direction d'aimantation de la couche de stockage ait lieu.

**6.** Procédé (3) de mesure de l'intensité d'un champ magnétique extérieur selon la revendication précédente **caractérisé en ce que** l'amplitude prédéfinie est une amplitude basse et **en ce que** l'amplitude modifiée est supérieure à l'amplitude basse.

**7.** Procédé (3) de mesure de l'intensité d'un champ magnétique extérieur selon l'une quelconque des revendications 1 à 3 **caractérisé en ce que** l'étape d'application successive d'une pluralité de courants ou de tensions d'amplitudes différentes jusqu'à ce qu'une commutation de la direction d'aimantation de la couche de stockage ait lieu comprend les sous-étapes de:

- Application d'une rampe ou d'un signal périodique de courant ou de tension, d'une polarité favorisant la commutation de la couche de stockage vers une direction opposée à la direction d'aimantation initiale relative de la couche de stockage par rapport à la couche de référence, jusqu'à ce qu'une commutation de la direction d'aimantation de la couche de stockage soit détectée,

- Détermination de l'amplitude de courant minimale de commutation ou de tension minimale de commutation en fonction du temps total d'application de la rampe de courant ou de tension pour obtenir la valeur du courant minimal de commutation ou de la tension minimale de commutation.

**8.** Procédé (3) de mesure de l'intensité d'un champ magnétique extérieur selon l'une quelconque des revendications précédentes **caractérisé en ce qu'**il comprend une étape supplémentaire d'application d'une impulsion après la détection d'une commutation de la direction d'aimantation de la couche de stockage, l'impulsion ayant une polarité favorisant la commutation de la couche de stockage vers la direction d'aimantation initiale relative de la couche de stockage par rapport à la couche de référence et ayant une amplitude supérieure à l'amplitude du courant minimal de commutation ou de la tension minimale de commutation.

**9.** Procédé (3) de mesure de l'intensité d'un champ magnétique extérieur selon l'une quelconque des revendications précédentes **caractérisé en ce qu'**il utilise une pluralité de points mémoire magnétiques, et **en ce que** l'étape d'application successive d'une pluralité de courants ou de tensions d'amplitudes différentes est réalisée en parallèle pour les points mémoire magnétique de la pluralité de points mémoire magnétiques.

**10.** Procédé (3) de mesure de l'intensité d'un champ magnétique extérieur selon la revendication précédente **caractérisé en ce que** l'étape d'application successive d'une pluralité de courants ou de tensions d'amplitudes différentes en parallèle est réalisée simultanément pour chaque point mémoire magnétique de la pluralité de points mémoire magnétiques et **en ce que** la valeur de courant minimal ou la valeur de tension minimale de commutation de la direction d'aimantation est la valeur de courant minimal ou de tension minimale de commutation de la direction d'aimantation de la couche de stockage de chaque point mémoire magnétique de la pluralité de points mémoire magnétiques.

**11.** Point mémoire magnétique (10 ; 10b ; 10c) **caractérisé en ce qu'**il est configuré pour mettre en oeuvre le procédé de mesure d'un champ magnétique extérieur selon l'une quelconque des revendications précédentes, et **en ce qu'**il comprend en outre un contrôleur (20) configuré pour gérer la mesure de la résistance du point mémoire magnétique.

**12.** Point mémoire magnétique (10 ; 10b ; 10c) selon la revendication précédente **caractérisé en ce qu'**il comporte une jonction tunnel magnétique à aimantation hors du plan (ou anisotropie perpendiculaire)

**13.** Point mémoire magnétique (10 ; 10b ; 10c) selon la revendication 11 ou 12, ledit point mémoire magnétique étant **caractérisé, en ce qu'**il comprend en outre un générateur d'impulsions (30) et **en ce que** le contrôleur (20) est en outre configuré pour gérer le générateur d'impulsions.

**14.** Point mémoire magnétique (10 ; 10b ; 10c) selon l'une quelconque des revendications 11 à 13 **caractérisé en ce qu'**il a des dimensions latérales inférieures à 200nm.

**15.** Procédé de détermination de la distance relative entre un point mémoire magnétique (10) selon l'une quelconque des revendication 11 à 14 et un objet magnétique (40) générant un champ magnétique entre 1mT et 500mT, le procédé étant **caractérisé en ce qu'**il comprend les étapes de :

- Mesure de la composante perpendiculaire d'un champ magnétique selon le procédé de mesure d'un champ magnétique extérieur selon l'une quelconque des revendications 1 à 10 en une pluralité de points de l'espace pour déterminer une amplitude et une direction du champ magnétique,
- Calcul de la distance relative entre la couche de stockage du point mémoire magnétique et l'objet magnétique à partir de simulations du champ magnétique généré par l'objet magnétique.

**Patentansprüche**

**1.** Verfahren (3) zum Messen der Stärke eines externen Magnetfelds unter Verwendung von mindestens einem magnetischen Speicherpunkt (10; 10b; 10c), umfassend:

- eine Speicherschicht (101) mit einer Magnetisierung (102), die zwischen zwei Magnetisierungsrichtungen umschaltbar ist, die im Wesentlichen senkrecht zur Ebene der Schicht liegen;
- eine Referenzschicht (107) mit einer festen Magnetisierung (106), die senkrecht zur Ebene der Schicht verläuft;
- eine Tunnelsperrschicht (105), die die Speicherschicht (101) und die Referenzschicht (107) trennt;

wobei das Verfahren **dadurch gekennzeichnet ist, dass** es mindestens Folgendes umfasst:

- einen Schritt des sukzessiven Anlegens einer Vielzahl von Strömen oder Spannungen mit unterschiedlichen Amplituden an den mindestens einen Speicherpunkt, bis ein Umschalten der Magnetisierungsrichtung der Speicherschicht stattfindet, um einen minimalen Umschaltstromwert der Magnetisierungsrichtung der Speicherschicht oder einen minimalen Umschaltspannungswert der Magnetisierungsrichtung der Speicherschicht zu bestimmen, wobei ein Umschalten der Magnetisierungsrichtung der Speicherschicht das Umschalten der Magnetisierungsrichtung der Speicherschicht von einer Konfiguration parallel zur Magnetisierungsrichtung der Referenzschicht zu einer Konfiguration antiparallel zur Magnetisierungsrichtung der Referenzschicht oder das Umschalten von einer Konfiguration antiparallel zur Magnetisierungsrichtung der Referenzschicht zu einer Konfiguration parallel zur Magnetisierungsrichtung der Referenzschicht in Abhängigkeit von einer anfänglichen Magnetisierungsrichtung der Speicherschicht ist,
- einen Schritt zum Bestimmen der Stärke des zu messenden externen Magnetfelds anhand des Werts des minimalen Schaltstroms oder des Werts der minimalen Schaltspannung.

**2.** Verfahren (3) zum Messen der Stärke eines externen Magnetfelds nach dem vorhergehenden Anspruch, **dadurch gekennzeichnet, dass** der mindestens eine Speicherpunkt (10; 10b; 10c) ein magnetischer Tunnelübergang mit einer Magnetisierung außerhalb der Ebene ist.

**3.** Verfahren (3) zum Messen der Stärke eines externen Magnetfelds nach Anspruch 1 oder 2, **dadurch gekennzeichnet, dass** der Schritt des Bestimmens der Stärke des externen Magnetfelds außerdem mindestens die folgenden Unterschritte umfasst:

- Berechnen der Differenz zwischen dem minimalen Schaltstromwert oder dem minimalen Schaltspannungswert und mindestens einem Referenzschaltstromwert oder Referenzschaltspannungswert, der nach demselben Verfahren unter einem externen Referenzmagnetfeld gemessen wurde, und
- Berechnen eines Magnetfeldstärkewerts, umfassend das Multiplizieren der Differenz zwischen dem minimalen Schaltstromwert oder dem minimalen Schaltspannungswert und dem mindestens einen Referenzschaltstromwert oder Referenzschaltspannungswert mit einer Proportionalitätskonstante und das Addieren des erhaltenen Werts zu dem Referenzmagnetfeldstärkenwert.

**4.** Verfahren (3) zum Messen der Stärke eines externen Magnetfelds nach dem vorhergehenden Anspruch, **dadurch gekennzeichnet, dass** die Proportionalitätskonstante bestimmt wird, indem ein Verhältnis zwischen der Differenz zwischen einem Kalibrierungsschaltstromwert oder Kalibrierungsschaltspannungswert und einem Referenzschaltstromwert oder Referenzschaltspannungswert und der Differenz zwischen einem Kalibrierungsmagnetfeldstärkenwert und einem Referenzmagnetfeldstärkenwert berechnet wird.

**5.** Verfahren (3) zum Messen der Stärke eines externen Magnetfelds nach einem der vorhergehenden Ansprüche, **dadurch gekennzeichnet, dass** der Schritt des sukzessiven Anlegens einer Vielzahl von Strömen oder Spannungen mit unterschiedlichen Amplituden, bis eine Umschaltung der Magnetisierungsrichtung der Speicherschicht stattfindet, folgende Unterschritte umfasst:

- Bestimmen eines ersten Widerstands des mindestens einen magnetischen Speicherpunkts, wobei das Bestimmen des ersten Widerstands das Messen eines Stroms oder einer Spannung über dem magnetischen Speicherpunkt umfasst,
- Vergleichen des erhaltenen ersten Widerstands mit einem Referenzwiderstandswert, um eine relative Anfangsmagnetisierungsrichtung der Speicherschicht in Bezug auf die Referenzschicht zu identifizieren,
- Anlegen eines Strom- oder Spannungsimpulses mit einer vordefinierten Amplitude und Polarität an den mindestens einen magnetischen Speicherpunkt, der das Schalten der Speicherschicht in eine Richtung entgegengesetzt zur relativen Anfangsmagnetisierungsrichtung der Speicherschicht in Bezug auf die Referenzschicht fördert,
- Bestimmen eines zweiten Widerstands des mindestens einen magnetischen Speicherpunkts, wobei das Bestimmen des zweiten Widerstands das Messen eines Stroms oder einer Spannung über dem magnetischen Speicherpunkt nach dem Anlegen eines Strom- oder Spannungsimpulses an den magnetischen Speicherpunkt umfasst,
- Vergleich des erhaltenen zweiten Widerstands mit dem Referenzwiderstandswert, um festzustellen, ob ein Umschalten der Magnetisierungsrichtung der Speicherschicht stattgefunden hat,
- Wenn eine Umschaltung der Magnetisierungsrichtung der Speicherschicht stattgefunden hat:

o ist der minimale Schaltstrom oder die minimale Schaltspannung der Strom oder die Spannung, der/die im vorherigen Schritt des Anlegens eines Strom- oder Spannungsimpulses an den Magnetspeicherpunkt angelegt wurde,

- Wenn kein Umschalten der Magnetisierungsrichtung der Speicherschicht stattgefunden hat, werden die Teilschritte Anlegen eines Strom- oder Spannungsimpulses an den magnetischen Speicherpunkt, Bestimmen eines zweiten Widerstands und Vergleichen des zweiten Widerstands mit dem ersten Widerstand mit einem Strom- oder Spannungsimpuls mit einer veränderten Amplitude, die sich von der vorgegebenen Amplitude unterscheidet, wiederholt, bis ein Umschalten der Magnetisierungsrichtung der Speicherschicht stattgefunden hat.

**6.** Verfahren (3) zum Messen der Stärke eines externen Magnetfelds nach dem vorhergehenden Anspruch, **dadurch gekennzeichnet, dass** die vorgegebene Amplitude eine niedrige Amplitude ist und dass die modifizierte Amplitude größer als die niedrige Amplitude ist.

**7.** Verfahren (3) zum Messen der Stärke eines externen Magnetfelds nach einem der Ansprüche 1 bis 3, **dadurch gekennzeichnet, dass** der Schritt des sukzessiven Anlegens einer Vielzahl von Strömen oder Spannungen mit unterschiedlichen Amplituden, bis eine Umschaltung der Magnetisierungsrichtung der Speicherschicht stattfindet, folgende Unterschritte umfasst:

- Anlegen einer Rampe oder eines periodischen Strom- oder Spannungssignals mit einer Polarität, die das Umschalten der Speicherschicht in eine Richtung entgegengesetzt zur anfänglichen relativen Magnetisierungsrichtung der Speicherschicht in Bezug auf die Referenzschicht fördert, bis ein Umschalten der Magnetisierungsrichtung der Speicherschicht erfasst wird,
- Bestimmen der Amplitude des minimalen Umschaltstroms oder der minimalen Umschaltspannung in Abhängigkeit von der Gesamtzeit, in der die Strom- oder Spannungsrampe anliegt, um den Wert des minimalen Umschaltstroms oder der minimalen Umschaltspannung zu erhalten.

**8.** Verfahren (3) zum Messen der Stärke eines externen Magnetfelds nach einem der vorhergehenden Ansprüche, **dadurch gekennzeichnet, dass** es einen zusätzlichen Schritt des Anlegens eines Impulses nach dem Erfassen eines Umschaltens der Magnetisierungsrichtung der Speicherschicht umfasst, wobei der Impuls eine Polarität aufweist, die das Umschalten der Speicherschicht in Richtung der anfänglichen relativen Magnetisierungsrichtung der Speicherschicht in Bezug auf die Referenzschicht begünstigt, und eine Amplitude aufweist, die größer ist als die Amplitude des minimalen Umschaltstroms oder der minimalen Umschaltspannung.

**9.** Verfahren (3) zum Messen der Stärke eines externen Magnetfelds nach einem der vorhergehenden Ansprüche, **dadurch gekennzeichnet, dass** es eine Vielzahl von magnetischen Speicherpunkten verwendet und dass der Schritt des sukzessiven Anlegens einer Vielzahl von Strömen oder Spannungen mit unterschiedlichen Amplituden für die magnetischen Speicherpunkte der Vielzahl von magnetischen Speicherpunkten parallel durchgeführt wird.

**10.** Verfahren (3) zum Messen der Stärke eines externen Magnetfelds nach dem vorhergehenden Anspruch, **dadurch gekennzeichnet, dass** der Schritt des sukzessiven Anlegens einer Vielzahl von Strömen oder Spannungen mit unterschiedlichen Amplituden parallel für jeden magnetischen Speicherpunkt der Vielzahl von magnetischen Speicherpunkten gleichzeitig durchgeführt wird und dass der minimale Stromwert oder der minimale Schaltspannungswert der Magnetisierungsrichtung der minimale Stromwert oder der minimale Schaltspannungswert der Magnetisierungsrichtung der Speicherschicht jedes magnetischen Speicherpunkts der Vielzahl von magnetischen Speicherpunkten ist.

**11.** Magnetischer Speicherpunkt (10; 10b; 10c), **dadurch gekennzeichnet, dass** er so konfiguriert ist, dass er das Verfahren zum Messen eines externen Magnetfelds gemäß einem der vorhergehenden Ansprüche ausführt, und dass er ferner eine Steuereinheit (20) umfasst, die so konfiguriert ist, dass sie die Messung des Widerstands des magnetischen Speicherpunkts steuert.

**12.** Magnetischer Speicherpunkt (10; 10b; 10c) nach dem vorhergehenden Anspruch, **dadurch gekennzeichnet, dass** er einen magnetischen Tunnelübergang mit Magnetisierung außerhalb der Ebene (oder senkrechte Anisotropie) umfasst.

**13.** Magnetischer Speicherpunkt (10; 10b; 10c) nach Anspruch 11 oder 12, bei dem der magnetische Speicherpunkt **dadurch gekennzeichnet ist, dass** er weiterhin einen Impulsgenerator (30) umfasst und dass die Steuerung (20) weiterhin so konfiguriert ist, dass sie den Impulsgenerator steuert.

**14.** Magnetischer Speicherpunkt (10; 10b; 10c) nach einem der Ansprüche 11 bis 13, **dadurch gekenn-**

**zeichnet, dass** er Seitenabmessungen von weniger als 200 nm aufweist.

**15.** Verfahren zum Bestimmen des relativen Abstands zwischen einem magnetischen Speicherpunkt (10) nach einem der Ansprüche 11 bis 14 und einem magnetischen Objekt (40), das ein Magnetfeld zwischen 1mT und 500mT erzeugt, wobei das Verfahren **dadurch gekennzeichnet ist, dass** es die folgenden Schritte umfasst:

- Messen der senkrechten Komponente eines Magnetfelds gemäß dem Verfahren zur Messung eines externen Magnetfelds nach einem der Ansprüche 1 bis 10 an einer Vielzahl von Punkten im Raum, um eine Amplitude und eine Richtung des Magnetfelds zu bestimmen,
- Berechnen des relativen Abstands zwischen der Speicherschicht des magnetischen Speicherpunkts und dem magnetischen Objekt anhand von Simulationen des vom magnetischen Objekt erzeugten Magnetfelds.

## Claims

**1.** A method (3) for measuring the intensity of an external magnetic field by using at least one magnetic memory point (10 ; 10b ; 10c) comprising:

- a storage layer (101) having a magnetisation (102) switchable between two magnetisation directions substantially perpendicular to the plane of the layer;
- a reference layer (107) having a fixed magnetisation (106) perpendicular to the plane of the layer; and
- a tunnel barrier layer (105) separating the storage layer (101) and the reference layer (107);

the method being **characterised in that** it comprises at least:

- a step of successively applying a plurality of currents or voltages of different amplitudes to said at least one memory point until switching of the magnetisation direction of the storage layer takes place to determine a minimum switching current value of the magnetisation direction of the storage layer or a minimum switching voltage value of the magnetisation direction of the storage layer, switching of the magnetisation direction of the storage layer being switching of the magnetisation direction of the storage layer from a configuration parallel to the magnetisation direction of the reference layer to a configuration antiparallel to the magnetisation direction of the reference layer or switching from a configuration antiparallel to the magnetisation direction of the reference layer to a configuration parallel to the magnetisation direction of the reference layer as a function of an initial magnetisation direction of the storage layer,
- a step of determining the intensity of the external magnetic field to be measured from the value of the minimum switching current or the value of the minimum switching voltage.

**2.** The method (3) for measuring the intensity of an external magnetic field according to the preceding claim, **characterised in that** said at least one memory point (10 ; 10b ; 10c) is a magnetic tunnel junction with out-of-plane magnetisation.

**3.** The method (3) for measuring the intensity of an external magnetic field according to claim 1 or 2, **characterised in that** the step (36) of determining the intensity of the external magnetic field further comprises at least the substeps of:

- calculating the difference between the minimum switching current value or the minimum switching voltage value and at least one reference switching current value or reference switching voltage value measured according to the same method under a reference external magnetic field and
- calculating a magnetic field intensity value comprising multiplying the difference between the minimum switching current value or the minimum switching voltage value and the at least one reference switching current value or reference switching voltage value by a proportionality constant and adding the value obtained to the reference field intensity value.

**4.** The method (3) for measuring the intensity of an external magnetic field according to the preceding claim, **characterised in that** the proportionality constant is determined by calculating a ratio of the difference between a calibration switching current value or calibration switching voltage value and a reference switching current value or reference switching voltage value to the difference between an intensity value of a calibration magnetic field and an intensity value of the reference magnetic field.

**5.** The method (3) for measuring the intensity of an external magnetic field according to any of the preceding claims, **characterised in that** the step of successively applying a plurality of currents or voltages of different amplitudes until switching of the magnetisation direction of the storage layer takes place comprises the substeps of:

- determining a first resistance of said at least one magnetic memory point, determining the first resistance comprising measuring a current or voltage across the magnetic memory point,
- comparing the first resistance obtained to a reference resistance value to identify a relative initial magnetisation direction of the storage layer with respect to the reference layer,
- applying to said at least one magnetic memory point a current or voltage pulse of a predefined amplitude and polarity promoting switching of the storage layer to an opposite direction to the relative initial magnetisation direction of the storage layer with respect to the reference layer,
- determining a second resistance of said at least one magnetic memory point, determining the second resistance comprising measuring a current or voltage across the magnetic memory point after applying a current or voltage pulse to the magnetic memory point,
- comparing the second resistance obtained to the reference resistance value to determine whether switching of the magnetisation direction of the storage layer has taken place,
- If switching of the magnetisation direction of the storage layer has taken place:

◦ the minimum switching current or the minimum switching voltage is the current or voltage applied in the previous step of applying a current or voltage pulse to the magnetic memory point,

- If switching of the magnetisation direction of the storage layer has not taken place, the substeps of applying a current or voltage pulse to the magnetic memory point, determining a second resistance and comparing the second resistance to the first resistance are repeated with a current or voltage pulse of a modified amplitude different from the predefined amplitude until switching of the magnetisation direction of the storage layer takes place.

**6.** The method (3) for measuring the intensity of an external magnetic field according to the preceding claim, **characterised in that** the predefined amplitude is a low amplitude and the modified amplitude is greater than the low amplitude.

**7.** The method (3) for measuring the intensity of an external magnetic field according to any of claims 1 to 3, **characterised in that** the step of successively applying a plurality of currents or voltages of different amplitudes until switching of the magnetisation direction of the storage layer takes place comprises the substeps of:

- Applying a current or voltage ramp or periodic signal, of a polarity promoting switching of the storage layer to an opposite direction to the relative initial magnetisation direction of the storage layer with respect to the reference layer, until switching of the magnetisation direction of the storage layer is detected,
- Determining the minimum switching current or minimum switching voltage amplitude as a function of the total application time of the current or voltage ramp to obtain the value of the minimum switching current or the minimum switching voltage.

**8.** The method (3) for measuring the intensity of an external magnetic field according to any of the preceding claims, **characterised in that** it comprises a further step of applying a pulse after detecting switching of the magnetisation direction of the storage layer, the pulse having a polarity promoting switching of the storage layer to the relative initial magnetisation direction of the storage layer with respect to the reference layer and having an amplitude greater than the amplitude of the minimum switching current or the minimum switching voltage

**9.** The method (3) for measuring the intensity of an external magnetic field according to any of the preceding claims, **characterised in that** it uses a plurality of magnetic memory points, and **in that** the step of successively applying a plurality of currents or voltages of different amplitudes is performed in parallel for the magnetic memory points of the plurality of magnetic memory points.

**10.** The method (3) for measuring the intensity of an external magnetic field according to the preceding claim, **characterised in that** the step of successively applying a plurality of currents or voltages of different amplitudes in parallel is performed simultaneously for each magnetic memory point of the plurality of magnetic memory points and **in that** the minimum switching current value or the minimum switching voltage value of the magnetisation direction is the minimum switching current or minimum switching voltage value of the magnetisation direction of the storage layer of each magnetic memory point of the plurality of magnetic memory points.

**11.** A magnetic memory point (10 ; 10b ; 10c) **characterised in that** it is configured to implement the method for measuring an external magnetic field according to any of the preceding claims, and **in that** it further comprises a controller (20) configured to manage the measurement of the resistance of the magnetic memory point.

**12.** The magnetic memory point (10 ; 10b ; 10c) according to the preceding claim, **characterised in that** it includes a magnetic tunnel junction with out-of-plane magnetisation (or perpendicular anisotropy).

**13.** The magnetic memory point (10; 10b ; 10c) according to claim 11 or 12, said magnetic memory point being **characterised in that** it further comprises a pulse generator (30) and **in that** the controller (20) is further configured to manage the pulse generator.

**14.** The magnetic memory point (10 ; 10b ; 10c) according to any of claims 11 to 13, **characterised in that** it has lateral dimensions of less than 200 nm.

**15.** A method for determining the relative distance between a magnetic memory point (10) according to any of claims 11 to 14 and a magnetic object (40) generating a magnetic field between 1 mT and 500 mT, the method being **characterised in that** it comprises the steps of:

- Measuring the perpendicular component of a magnetic field according to the method for measuring an external magnetic field according to any of claims 1 to 10 at a plurality of points in space to determine an amplitude and a direction of the magnetic field,
- Calculating the relative distance between the storage layer of the magnetic memory point and the magnetic object from simulations of the magnetic field generated by the magnetic object.

1
101
102
103
10
104
105
107
106

Fig. 1A

1b
101
102
103
10b
104
105
107
106
107b
108
109
110

Fig. 1B

1c
101
102
103
10c
104
105
107
106
107b
108
109
110

Fig. 2

3
34
31
32
33
35
36
37

Fig. 3

2
20
30
101
102
103
104
105
106
107
107b
108
109
110
10c
V
Fig. 4

Fig. 5
Portée de détection de champ
Tension d'impulsion (V)
0.5
0.4
0.3
0.2
0.1
0
-0.1
-0.2
-0.3
-0.4
-0.5
Haute résistance
Résistance haute ou basse
Basse résistance
Série d'amplitudes d'impulsion croissantes
-500
0
500
Field (Oe)

Tension de commutation (V)
0.4
0.2
Diamètre: 200 nm
-500
500
Champ magnétique (Oe)
Tension de commutation (V)
0.6
0.4
0.2
Diamètre : 50 nm
-1000
-500
500
Champ magnétique (Oe)

Fig. 6

Linéarité champ-tension
3.5x10-2
3.0x10-2
2.5x10-2
2.0x10-2
1.5x10-2
1.0x10-2
5.0x10-3
Erreur de linéarité (%)
Average
50
100
150
200
250
300
Diamètre du dispositif (nm)

Fig. 7

Diamètre : 50 nm
Diamètre : 200nm
Diamètre : 500nm
Voltage (V)
Field (Oe)
Resistance (Ohm)
Limite entre tension et champ : linéaire
Limite entre tension et champ : non-linéaire
Limite entre tension et champ : Fortement non-linéaire

Fig. 8

40
Courbes du champ magnétique
10
Mouvement relatif selon la direction verticale
Mouvement relatif selon la direction horizontale

Fig. 9

Courant jonction
A
i
j
k
l
temps
Configuration magnétique parallèle de basse résistance
Configuration magnétique antiparallèle de haute résistance
Courant jonction
B
i
j
k
l
temps
Configuration magnétique parallèle de basse résistance
Configuration magnétique antiparallèle de haute résistance

Fig. 10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- EP 3528256 A1

### Littérature non-brevet citée dans la description

- **PARKIN et al.** *Phys. Rev. Lett,* 1991, vol. 67, 3598